(19) **Europäisches Patentamt**

**European Patent Office**

**Office européen des brevets**

(11) **EP 1 333 582 B1**

(12) **EUROPEAN PATENT SPECIFICATION**

(45) Date of publication and mention
of the grant of the patent:
**29.11.2006 Bulletin 2006/48**

(51) Int Cl.:
*H03M 1/06* (2006.01)

(21) Application number: **02077450.1**

(22) Date of filing: **20.06.2002**

(54) **Averaging amplifier array**

Mittelwertbildende Verstärkermatrix

Matrice d'amplificateurs avec établissement de la moyenne

(84) Designated Contracting States:
**DE FR GB NL**

(30) Priority: **30.01.2002 EP 02075470**

(43) Date of publication of application:
**06.08.2003 Bulletin 2003/32**

(73) Proprietor: **Koninklijke Philips Electronics N.V.
5621 BA Eindhoven (NL)**

(72) Inventor: **Scholtens, Peter Cornelis Simeon
5656 AA Eindhoven (NL)**

(74) Representative: **Duijvestijn, Adrianus Johannes et
al
Philips
Intellectual Property & Standards
P.O. Box 220
5600 AE Eindhoven (NL)**

(56) References cited:
**US-A- 5 175 550        US-A- 5 291 198
US-A- 5 835 048**

- **SCHOLTENS P: "A 2.5 Volt 6b 600MS/s flash ADC
  in 0.25um CMOS" ESSCIRC 2000, 19 September
  2000 (2000-09-19), pages 196-199, XP009021594**
- **KATTMANN K ET AL: "A Technique For Reducing
  Differential Non-linearity Errors In Flash A/D
  Converters" SOLID-STATE CIRCUITS
  CONFERENCE, 1991. DIGEST OF TECHNICAL
  PAPERS. 38TH ISSCC., 1991 IEEE
  INTERNATIONAL SAN FRANCISCO, CA, USA
  13-15 FEB. 1991, NEW YORK, NY, USA,IEEE, US,
  13 February 1991 (1991-02-13), pages 170-171,
  XP010039676 ISBN: 0-87942-644-6**

**Description**

The invention relates to an AD-converter as set forth in the preamble of claim 1.

Such an AD-converter is known from "A 6b 500MSample/s ADC for a Hard Disk Drive Read Channel", Tamba, Y, ISSCC'99, pp. 324-325, and comprises an averaging network to reduce the offsets of the amplifiers. However, applying averaging will create a load which depends on the position of the amplifier in the array. Through the averaging network, a shift in the zero crossing is introduced, compared to an ideal network wherein the amplifying circuits do not suffer from offset errors. Due to the finiteness of the array of amplifying circuits, the zero crossing is non-linear towards the outer circuits of the AD-converter array. In order to resemble an infinite array, the disclosed termination network comprises a series of "dummy" amplifiers. By using only a series of innermost amplifiers boundary effects are suppressed.

In this known solution, it is clear, that a termination will be more effective if more and more dummy amplifiers are used on either sides of the array, because an increase in the number of amplifiers will resemble an infinite array better. As an example, a number of 6 overrange amplifiers is used in case of an AD-convertor array comprising 16 AD-amplifiers, and for instance, 18 overrange amplifiers are used in case of 63 amplifier array.

The above mentioned disclosed embodiment suffers from the drawback, that linearity is not restored completely, but only approached to a limit, wherein for a better linearity, more and more dummy amplifiers are inserted. Besides an unsatisfying linearity, also the power dissipation and input capacitance of this embodiment are quite unprofitable.

An AD converter is also known from an article titled "A 2.5 Volt 6 bit 600MS/s Flash ADC in 0.25 $\mu$m CMOS, by the inventor, P. Scholtens and published in ESSCIRC 2000, pages 196-199, September 19, 2000 (EPO reference XP009021594). This publication discloses a termination network with termination impedances at its boundaries connected to a ground and power supply connections. This AD converter cannot eliminate boundary effects for all analog input voltage values.

The invention aims to obviate the above mentioned problem and has as one of its goals to provide an improved AD-converter, having improved linearity properties and less power dissipation.

In accordance with the invention, the AD-converter of the above mentioned type is characterized by the characterizing part of claim 1.

In other words, a termination circuit deviates in at least one of its constituting components from the amplifying circuits of the array. That is, the amplifying and/or impedance characteristics of said termination circuit deviate from the generally uniform amplifying and/or impedance characteristics of the amplifying circuits of the array; and/or a voltage difference between said termination reference voltage and a reference voltage received by an outer amplifying circuit deviates from a voltage difference between reference voltages of two adjacent amplifying circuits in the array; and/or a termination averaging impedance deviates from averaging impedances used in said array.

Throughout the remainder of the text, the term "deviant" or "deviates" is used in contrast to the term "generally uniform" in the above referenced context. The AD-converter according to the invention is especially beneficial since it offers a termination circuit with a minimum number of components, similar in design as the amplifying circuits of said array, thus eliminating the need for complicated, slow and/or power-absorbing extra circuits, while at the same time boundary effects may be eliminated rigorously, in contrast to the termination networks of the prior art, which merely seek to achieve a less-rigorous compensation for said boundary effects.

In a preferred embodiment, the amplifying and/or impedance characteristics of said termination circuit and/or the termination reference voltage, and/or the termination averaging impedance of said termination network deviate so that currents through each averaging impedance between adjacent output voltage terminals of said array are generally equal in magnitude. In this way, according to the invention, a termination of the AD-converter may be provided, wherein linearity of the array is optimally restored. The zero crossing of the termination amplifier circuit is shifted strongly, and therefore not usable, in favor of the recovered position of the zero crossing of amplifiers in the array. Such a redefinition of the edge termination circuit not only recovers the linearity at the edge, but also prevents propagation of an imbalance between amplifiers.

In one embodiment, the invention is characterized in that a voltage difference between said termination reference voltage and a reference voltage received by an outer amplifying circuit is larger as compared to the generally uniform spacing between each reference voltage received by said amplifier circuits, wherein the amplifying and impedance characteristics of said termination circuit and the termination averaging impedance are not deviant.

Specifically, in a preferred embodiment according to the invention, in an array comprising amplifier circuits having an output impedance of R1 and coupled by averaging impedances having a value of R2, the voltage difference is preferably a factor $\dfrac{R1 + R2}{R2}$ larger compared to said uniform spacing. In this preferred embodiment an output terminal may also be coupled to the termination circuit, since the voltage difference over the averaging resistor is generally equal to the differences of the averaging resistors of the rest of the amplifying circuits. This modification has as a special advantage that no dummy circuit whatsoever needs to be active in order to restore linearity properties.

In yet another preferred embodiment, in an array comprising amplifier circuits having an output impedance of R1 and coupled by averaging impedances having a value of R2, the termination averaging impedance equals R2-R1, wherein the amplifying and impedance characteristics of said termination circuit and the termination reference voltage are not deviant. Again, since the averaging impedance is left unaltered, an output terminal may also be coupled to the termination circuit.

In still another embodiment wherein $R1 > R2$, in an array comprising amplifier circuits having an output impedance of R1 and coupled by averaging impedances having a value of R2, the termination averaging impedance may be created by an active circuit, wherein the amplifying and impedance characteristics of said termination circuit and the termination reference voltage are not deviant. By such an active circuit, an effective negative impedance may be created in order to achieve the termination according to the invention.

Specifically, in the case wherein $R1 > R2$, the termination network may comprise a plurality of termination circuits, wherein at least two output voltage terminals of two adjacent termination circuits are short-circuited. Therefore, according to an aspect of the invention, by short-circuiting the outer output voltage terminals, linearity of the inner output voltage terminals is restored.

More specifically, the termination network comprises two termination circuits comprising output voltage terminals which are short circuited, the amplifying circuits further receiving an equally spaced referenced voltage and being connected to the input voltage, wherein the output voltage terminals of said amplifying circuits are coupled by a termination averaging impedance to an output voltage terminal of an outer amplifying circuit of said array, the termination averaging impedance equaling $\frac{3}{2}R2 - \frac{1}{2}R1$, wherein the amplifying and impedance characteristics of said termination circuit and the termination reference voltages are not deviant.

The invention further relates to a method according to Claim 10.

According to the method of the invention it becomes apparent, that, even if a first step calculation indicates a design where unphysical properties of the termination averaging impedance are required, such a requirement can be met by "offering" an outer amplifying circuit of the array, which thereby becomes a part of the termination network; and recalculate the desired termination impedances of the next adjacent termination circuit. In this way, the required termination averaging impedance will become more positive, and after repeating the above mentioned steps, a positive dimensioned termination averaging impedance can be calculated for correcting the array according to the invention.

Further objects and features of the invention will become apparent from the drawings, wherein:

Fig. 1 shows a schematic illustration of an AD-converter according to the prior art;
Fig. 2 shows a small-signal equivalent circuit of an AD-converter according to the invention;
Fig. 3 shows a first embodiment of an AD-converter according to the invention;
Fig. 4 shows a second embodiment of an AD-converter according to the invention;
Fig. 5 shows a third embodiment of an AD-converter according to the invention; and
Fig. 6 shows a fourth embodiment of an AD-converter according to the invention.

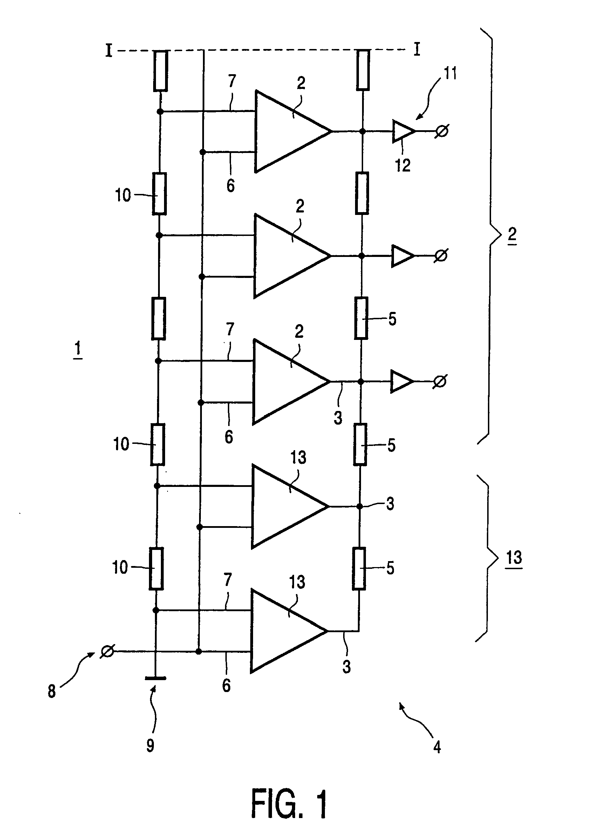

In Fig. 1 a schematic illustration is presented of an AD-converter 1 according to the prior art. In the drawing, only a lower half of the array 1 is illustrated, terminated by the line I-I. The AD-converter 1 is for instance used in magnetic or optical storage systems. Due to the threshold voltage mismatch, the amplifiers 2 will suffer from an offset if no precautions are taken. However, to profit of the maximum bandwidth of the technology used the amplifiers 2 do not have a conventional offset correction. The illustrated topology is a flash ADC: an array 1 of amplifiers 2 each receiving a slightly different reference input voltage level. To reduce the influence of the offset of the array of parallel amplifiers 2, output voltage terminals 3 of each amplifying circuit 2 are coupled to output voltage terminals 3 of adjacent amplifying circuits 2 through an averaging network 4 comprising resistors 5. The amplifying circuits 2 further comprise at least an input voltage terminal 6 and a reference voltage terminal 7 for amplifying a voltage difference received between said terminals 6,7. An input voltage network 8 is present for applying an analog input voltage to each input voltage terminal 6 of each amplifying circuit 2; a reference voltage network 9 comprises a series of reference impedances 10 of a general uniform magnitude, for generating reference voltages of a generally uniformly spacing for each reference voltage terminal 7 of said amplifying circuits 2. The array 1 further comprises an output voltage network 11 for outputting an output voltage received on output voltage terminals 3 by means of for example amplifiers or source-followers 12.

The AD-converter according to the prior art is designed as an array of generally uniform amplifying circuits 2 with substantially identical amplifying and impedance characteristics. In such an array 1, due to the averaging network 4 of resistors 5, a shift in the zero crossing is introduced, compared to an ideal network wherein the amplifying circuits do not suffer from offset errors. Due to the finiteness of the array 1 of amplifying circuits 2, the zero crossing is non-linear towards the outer circuits of the AD-converter array 1. In order to resemble an infinite array, the termination network of the prior art comprises a series of "dummy" amplifiers 13 which are not coupled to the output voltage network 11. In this way only the innermost amplifying circuits 2, which have relatively optimal linearity properties, are used.

The prior art termination network is thus formed by outer amplifier circuits 13 of the array 1. These outer circuits 13 have a general identical structure as the amplifier circuits of the array, but are not coupled to the output network.

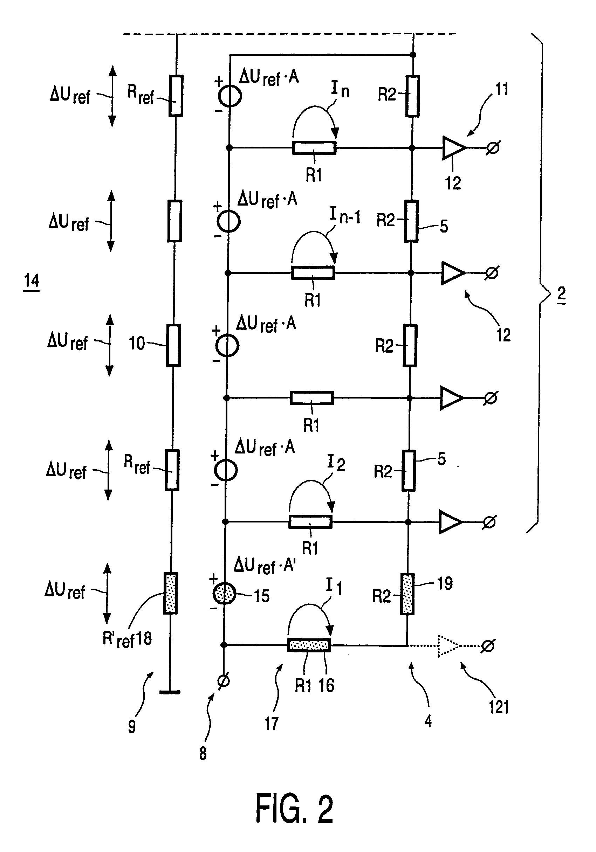

In contrast, in fig. 2 is illustrated a small-signal equivalent circuit of an array 14 according to the invention, having a general identical design as the array in fig. 1, that is, comprising amplifying circuits 2 of generally uniform amplifying and impedance characteristics, and further comprising an input voltage network 8, a reference voltage network 9, an averaging network 4, and an output voltage network 11 for outputting amplified voltage differences from each of said plurality of amplifying circuits 2. In the small-signal approximation, the amplifiers are modeled as a voltage source 15 and an output impedance 16. The array 14 according to the invention comprises a modified outer amplifying circuit or termination circuit 17, that is, a circuit deviantly dimensioned from the amplifying circuits 2 inside the array 1. This is illustrated in fig. 2 by the dotted electronic components constituting said termination circuit 17, specifically, a termination amplifying circuit 17 having deviant amplifying and/or impedance characteristics; a deviant reference impedance 18, and/or a deviant termination averaging impedance 19. By designing a termination circuit according to the invention, an electric current in the output voltage terminal of the outer amplifying circuits of the array is corrected for the finite size of the array 14. Specifically, according to the invention, the amplifying and/or impedance characteristics of said termination circuit 17 and/or the termination reference voltage 18, and/or the termination averaging impedance 19 of said termination network deviate so that currents through each averaging impedance 5, 19 between adjacent output voltage terminals of said array 14 are generally equal in magnitude.

A sub circuit analysis for an amplifying circuit n in the center of the array 1 yields the following equation (see fig.2):

$$\Delta U_{ref} \cdot A_u = R_1(I_n - I_{n+1}) + R_2 I_n + R_1(I_n - I_{n-1}) \qquad (1)$$

In this equation $\Delta U_{ref}$ represents a potential difference between subsequent reference voltage taps, $A_u$ represents the amplification of the amplifying circuit, $R_1$ represents an generally identical output impedance of said amplifying circuits and $R_2$ represents a generally identical averaging impedance between the output terminals of said amplifying circuits. The subcircuit currents of circuits n - 1, n and n+1 are represented by $I_{n+1}$, $I_n$ and $I_{n+1}$ respectively.

In case the circuit approximates an infinite long string of amplifiers and resistors in both directions, the current of each subcircuit equals the current of both neighboring subcircuits:

$$I_{n-1} \approx I_n \approx I_{n+1} \quad (n=1, 2, ..) \qquad (2)$$

From this equation, it follows that the current through $R_2$ (in fig. 2: reference numeral 5) equals:

$$I_{R2} = I_n \approx \frac{\Delta U \cdot A_u}{R_2} \qquad (3)$$

However, for an amplifying circuit 17 located at the outer ends of the array 14, the equation reads:

$$\Delta U_{ref} \cdot A_u = R_1(I_1 - I_2) + R'_2 I_1 + R'_1 I_1 \qquad (4)$$

In equation (4) values $R'_2$, $R'_1$ represent the averaging impedance and output impedance of the outer amplifying circuit 17. From this equation (4), it follows that the current through $R'_2$ equals:

$$I_1 = \frac{\Delta U_{ref} \cdot A_u + I_2 R_1}{R_1 + R'_1 + R'_2} \qquad (5)$$

Hence, it follows from equation (5) that by modifying the amplifying characteristics (expressed as $\Delta U_{ref} \cdot A_u$), and/or the impedances $R'_2$ (19) and $R'_1$ (16), the current $I_1$ can be modified by deviating the amplifying and/or impedance characteristics, termination reference voltage, and/or the termination averaging impedance 19 to generate a current in said output voltage terminal of said outer amplifying circuit 17 of said array 14 to be equal to the current $I_2$ ($I_n$) flowing through the rest of the amplifying circuits 2, thereby correcting for the finite size of the array 14.

It is noted that by a suitable modification of aforementioned electronic components, the averaging resistor $R'_2$ (19) may be left unaltered and generally equal to the other averaging resistors $R_2$. In that case an output terminal 121 may be coupled to the outer amplifying circuit 17, since not only the current in said circuit 17 remains generally equal to the currents $I_2$ ($I_n$) flowing through the rest of the amplifying circuits 2, but also the voltage difference over the averaging resistor $R'_2$ is generally equal to the differences of the averaging resistors $R_2$ of the rest of the amplifying circuits 2. This modification has as a special advantage that no dummy circuit whatsoever needs to be active in order to restore linearity properties.

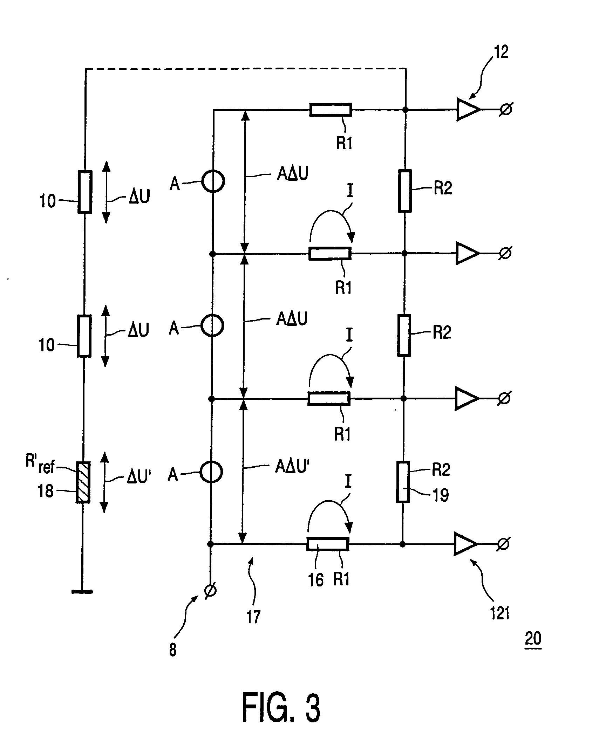

As a first embodiment, fig. 3 shows an example of an AD-converter 20 according to the invention wherein a voltage difference over an outer termination reference resistor 18 is larger than compared to the reference voltages over the other reference resistors 10. The output impedance 16 of circuit 17 and the averaging impedance 19 are not deviant, and are therefore equal to $R_1$, $R_2$, respectively. An output terminal 121 is coupled to the circuit 17. The amplifying characteristics denoted in the equations (1-5) by $A_u$ of said outer circuit 17 are also unchanged with respect to the amplifying characteristics of inner circuits 2. Specifically equation (4) now reads, for the termination circuit 17:

$$\Delta U'_{ref} \cdot A_u = R_1(I_1 - I_2) + R_2 I_1 + R_1 I_1 \qquad (6)$$

Linearity is restored when $I_1 = I_2$ and $I_2 R_2 = \Delta U_{ref} \cdot A_u$. It follows that:

$$\Delta U'_{ref} = \frac{R_1 + R_2}{R_2} \cdot \Delta U_{ref} \; (7)$$

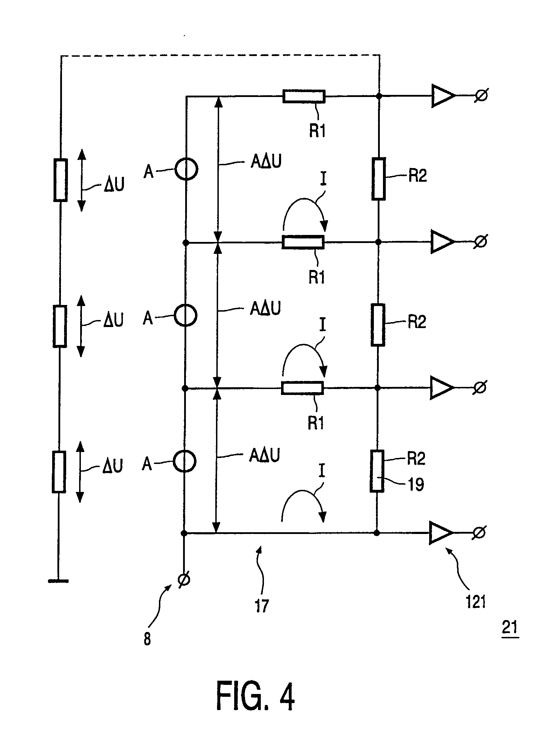

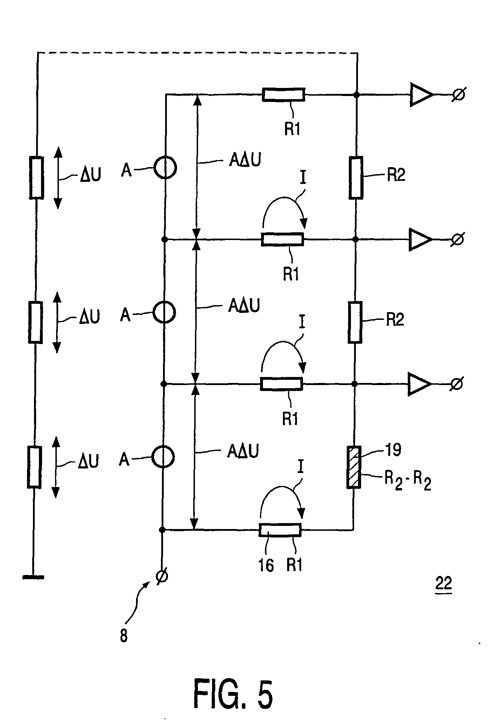

A further embodiment is shown in figs. 4 and 5. Herein, starting from equation (4), and setting $I_1 = I_2$ and $\Delta U_{ref} \cdot A_u = R_2 I_2$ yields:

$$R'_1 + R'_2 = R_2 \qquad (7)$$

It follows that equation (7) is a condition for an outer termination circuit to have a same sub circuit current as inner circuits.

In Fig. 4, an AD-converter 21 according to a second embodiment of the invention is illustrated, with a modified termination circuit , wherein equation (7) is satisfied by having $R'_1$ equal to zero; and $R'_2 = R_2$. This condition enables an output terminal to be coupled to the circuit. Hence, by requiring that the outer termination circuit has a zero output impedance, and further having the amplifying characteristics of said termination circuit, the termination reference voltage and the termination averaging impedance unmodified with respect to the inner circuits 2, the array 21 exhibits the improved linearity properties according to the invention.

In Fig. 5, still another embodiment of the invention is shown. In array 22, the amplifying and impedance characteristics of the termination circuit 17 and the termination reference voltage are relatively unchanged with respect to the amplifying circuits 2. However, the averaging impedance 19 now equals

$$R_2 - R_1, \text{ assuming } R_2 > R_1.$$

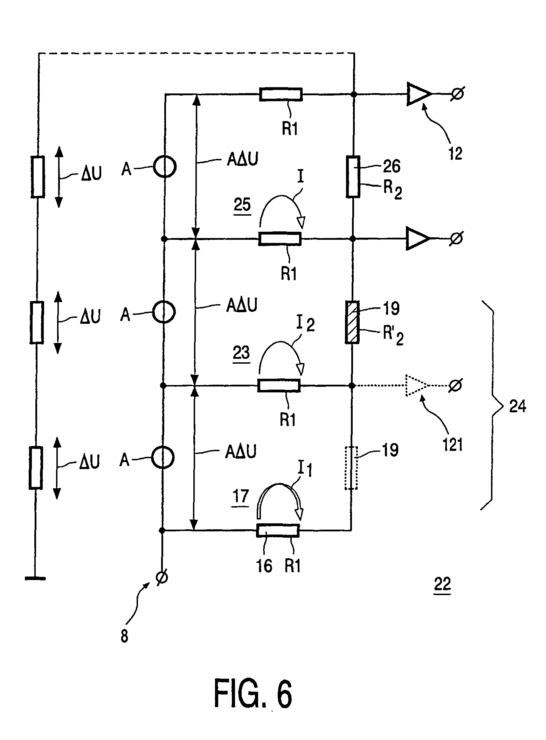

Fig. 6 shows an embodiment of the invention wherein the output impedance 16 $R_1$ is larger than the averaging impedance $R_2$, hence, $R_2 - R_1 < 0$.

The solution proposed in Fig. 5 is not valid for this case, since the modified termination averaging resistor 19 cannot have a negative value. However, the solution proposed in Fig. 6 resolves this by setting the averaging resistor 19 to zero, that is, short-circuiting the output voltage terminals of two outer circuits 17, 23 that are adjacent. Thus, a termination network 24 having the output voltage terminals 3 of termination circuits 17, 23 short-circuited, yields the following sub circuit equations for termination circuits 17 and 23 (denoted with subscripts 1 and 2 respectively):

$$17: \qquad \Delta U_{ref} \cdot A_u = R_1(I_1 - I_2) + R_1 I_1 \quad (8)$$

$$23: \qquad \Delta U_{ref} \cdot A_u = R_1(I_2 - I_n) + R'_2 I_2 + R_1(I_2 - I_1)$$

Linearity requires that $I_2 - I_n = 0$ and $\Delta U_{ref} \cdot A_u = R_2 I_2$; solving for $R'_2$ yields a termination impedance equaling $\frac{3}{2}R_2 - \frac{1}{2}R_1$, wherein the amplifying and impedance characteristics of said termination circuit and the termination reference voltages are not deviant.

It is shown, that in this way, the required negative termination resistor is provided by an extra amplifier. If the value for the required termination averaging resistor $R'_2$, having a value of $\frac{3}{2}R_2 - \frac{1}{2}R_1$, still yields a negative outcome, the method of short-circuiting can be repeated, hence, if said magnitude is negative, output voltage terminal of said termination circuit 23 is short-circuited output voltage terminal 3 of next adjacent circuit 24 (equivalent to setting $R'_2$ to zero); and calculating a magnitude of a next termination impedance 24 coupling a next output voltage terminal of said termination circuit 26 to a next output voltage terminal of an amplifying circuit adjacent to said termination circuit 25.

Depending on the actual value of $R'_2$ (i.e. if $R'_2$ equals $R_2$), an output terminal 121 may be coupled to the circuit 17 (in the drawing shown as optional by dashed lines).

**Claims**

1. An AD-converter, comprising:

   an array of amplifying circuits (2) having generally uniform amplifying and impedance characteristics, each circuit comprising: an input voltage terminal (6) a reference voltage terminal (7), and an output voltage terminal (3);
   the AD converter furthermore comprising:

   an input voltage network (8) applying an analog input voltage to each input voltage terminal (6) of said amplifying circuits (2);
   a reference voltage network (10) applying reference voltages of a generally uniformly spacing to each reference voltage terminal (7) of said amplifying circuits (2), wherein a relative functional position of each amplifying circuit (2) is determined by the magnitude of a received reference voltage;
   an averaging network (5), comprising of generally identical averaging impedances (5) coupling output voltage terminals (3) of adjacent amplifying circuits (2);
   an output voltage network (12) for outputting amplified voltage differences from each of said plurality of amplifying circuits (2); and

   **characterized by**
   a termination network (13, 5) comprising a termination circuit (13) and a termination averaging impedance (5), said termination circuit (13) receiving the analog input voltage and a termination reference voltage and said termination circuit (13) comprising an output voltage terminal for producing an output voltage dependent on a difference between the analog input voltage and the termination reference voltage, the output voltage terminal being coupled through said termination averaging impedance (5) to an output voltage terminal (3) of an outer amplifying circuit (2) of said array, the amplifying and/or impedance characteristics of said termination circuit (13) and/or the termination reference voltage, and/or the termination averaging impedance (5) being deviant, to generate a current in said output voltage terminal of said outer amplifying circuit (2) of said array, that is corrected for the finite size of the array.

2. AD-converter according to claim 1, **characterized in that** the amplifying and/or impedance characteristics of said termination circuit (13) and/or the termination reference voltage, and/or the termination averaging impedance (5) of said termination network deviate so that currents through each averaging impedance between adjacent output voltage terminals of said array are generally equal in magnitude.

3. AD-converter according to claim 1 or 2, **characterized in that** a voltage difference between said termination reference voltage and a reference voltage received by an outer amplifying circuit is larger as compared to the generally uniform spacing between each reference voltage received by said amplifier circuits, wherein the amplifying and impedance characteristics of said termination circuit and the termination averaging impedance are not deviant.

4. AD-converter according to claim 3, **characterized in that** in an array comprising amplifier circuits having an output impedance of R1 and coupled by averaging impedances having a value of R2, the voltage difference is a factor

$$\frac{R1 + R2}{R2}$$ larger compared to said uniform spacing.

5. AD-converter according to claim 1 or 2, **characterized in that** in an array comprising amplifier circuits having an output impedance of R1 and coupled by averaging impedances having a value of R2, the termination averaging impedance equals R2-R1, wherein the amplifying and impedance characteristics of said termination circuit and the termination reference voltage are not deviant.

6. AD-converter according to claim 1 or 2, **characterized in that** in an array comprising amplifier circuits having an output impedance of R1 and coupled by averaging impedances having a value of R2, wherein $R1 > R2$ the termination averaging impedance is created by an active circuit, wherein the amplifying and impedance characteristics of said termination circuit and the termination reference voltage are not deviant.

7. AD-converter according to claim 8, **characterized in that** the termination network comprises a plurality of termination circuits, wherein at least two output voltage terminals of two adjacent termination circuits are short-circuited.

8. AD-converter according to claim 7, **characterized in that** the termination network comprises two termination circuits comprising output voltage terminals which are short circuited, the amplifying circuits further receiving an equally spaced referenced voltage and being connected to the input voltage, wherein the output voltage terminals of said amplifying circuits are coupled by a termination averaging impedance to an output voltage terminal of an outer amplifying circuit of said array, the termination averaging impedance equaling $\frac{3}{2}R_2 - \frac{1}{2}R_1$, wherein the amplifying and impedance characteristics of said termination circuit and the termination reference voltages are not deviant.

9. Method of designing an AD-converter according to at least one of the claims 1-8 wherein the amplifying and impedance characteristics of said termination circuit (13) and the termination reference voltage are generally uniform in magnitude, in an array comprising amplifier circuits having an output impedance of R1 and coupled by averaging impedances having a value of R2, wherein $R1 > R2$, the method comprising the steps of:

short-circuiting two output voltage terminals of two termination circuits in the termination network; and
the method further comprising repeating the steps of:

calculating a magnitude of a first termination impedance coupling an output voltage terminal of said termination circuits to a first output voltage terminal of an amplifying circuit adjacent to said termination circuit, so that a current through each averaging impedance between adjacent output voltage terminals of said array is generally equal in magnitude; and
if said calculated magnitude is negative, short circuiting said output voltage terminal of said termination circuit to said first output voltage terminal and calculating a magnitude of a next termination impedance coupling the output voltage terminal of said termination circuit to a next output voltage terminal of an amplifying circuit adjacent to said termination circuit.

**Patentansprüche**

1. Analog-Digitalwandler, der die nachfolgenden Elemente umfasst:

   - eine Anzahl Verstärkungsschaltungen (2) mit im Allgemeinen einheitlichen Verstärkungs- und Impedanzcharakteristiken, wobei jede Schaltungsanordnung die nachfolgenden Elemente umfasst:
   - eine Eingangsspannungsklemme (6);
   - eine Bezugsspannungsklemme (7); und
   - eine Ausgangsspannungsklemme (3);

   wobei der Analog-Digital-Wandler weiterhin die nachfolgenden Elemente umfasst:

   - ein Eingangsspannungsnetzwerk (8), das jeder Eingangsspannungsklemme (6) der genannten Verstärkungsschaltungen (2) eine analoge Eingangsspannung zuführt;
   - ein Bezugsspannungsnetzwerk (10), das jeder Bezugsspannungsklemme (7) der genannten Verstärkungsschaltungen (2) Bezugsspannungen mit einem im Allgemeinen einheitlichen Zwischenraum zuführt, wobei eine relative funktionelle Lage jeder Verstärkungsschaltung (2) durch die Größe einer empfangenen Bezugsspannung bestimmt wird;
   - ein Mittelwertbestimmungsnetzwerk (5), das aus im Allgemeinen identischen Mittelwertbestimmungsimpedanzen (5) besteht, die Ausgangsspannungsklemmen (3) aneinander grenzender Verstärkungsschaltungen (2) koppeln;
   - ein Ausgangsspannungsnetzwerk (12) zum Liefern verstärkter Spannungsdifferenzen von jeder Verstärkungsschaltung der genannten Anzahl Verstärkungsschaltungen (2); und

   **gekennzeichnet durch**

   - ein Abschlussnetzwerk (13, 5), das eine Abschlussschaltung (13) und eine Abschlussmittelwertbestimmungsimpedanz (5) aufweist, wobei die genannte Abschlussschaltung (13) die analoge Eingangsspannung sowie eine Abschlussbezugsspannung empfängt und die genannte Abschlussschaltung (13) eine Ausgangsspannungsklemme aufweist, zum Erzeugen einer Ausgangsspannung, und zwar abhängig von einer Differenz der analogen Eingangsspannung und der Abschlussbezugsspannung, wobei die Ausgangsspannungsklemme über die genannte Mittelwertbestimmungsimpedanz (5) mit einer Ausgangsspannungsklemme (3) einer äußeren Verstärkungsschaltung (2) der genannten Anordnung gekoppelt ist, wobei die Verstärkungs- und/oder Impedanzcharakteristiken der genannten Abschlussschaltung (13) und/oder die Abschlussbezugsspannung und/oder die Abschlussmittelwertbestimmungsimpedanz (5) abweichend sind zum Erzeugen eines Stroms in der genannten Ausgangsspannungsklemme der genannten äußeren Verstärkungsschaltung (2) der genannten Anordnung, die für die schlussendlichen Größe der Anordnung korrigiert wird.

2. Analog-Digitalwandler nach Anspruch 1, **dadurch gekennzeichnet, dass** die Verstärkungs- und/oder Impedanzcharakteristik der genannten Abschlussschaltung (13) und/oder die Abschlussbezugsspannung und/oder die Abschlussmittelwertbestimmungsimpedanz (5) des genannten Abschlussnetzwerkes abweichend sind, so dass Ströme durch jede Mittelwertbestimmungsimpedanz zwischen benachbarten Ausgangsspannungsklemmen der genannten Anordnung im Allgemeinen in der Größe einander gleich sind.

3. Analog-Digitalwandler nach Anspruch 1 oder 2, **dadurch gekennzeichnet, dass** eine Spannungsdifferenz zwischen der genannten Abschlussbezugsspannung und einer Bezugsspannung, die von einer Außenverstärkungsschaltung empfangen worden ist, größer ist im Vergleich zu dem im Allgemeinen einheitlichen Zwischenraum zwischen jeder Bezugsspannung, empfangen von den genannten Verstärkungsschaltungen, wobei die Verstärkungs- und die Impedanzcharakteristiken der genannten Abschlussschaltung und der Abschlussmittelwertbestimmungsimpedanz nicht abweichend sind.

4. Analog-Digitalwandler nach Anspruch 3, **dadurch gekennzeichnet, dass** in einer Anordnung mit Verstärkerschaltungen mit einer Ausgangsimpedanz von R1 und durch Mittelwertbestimmungsimpedanzen mit einem Wert R2 gekoppelt, die Spannungsdifferenz um einen Faktor $\dfrac{R1+R2}{R2}$ größer ist im Vergleich zu dem genannten einheitlichen Zwischenraum.

**5.** Analog-Digitalwandler nach Anspruch 1 oder 2, **dadurch gekennzeichnet, dass** in einer Anordnung mit Verstärkungsschaltungen mit einer Ausgangsimpedanz R 1 und durch Mittelwertbestimmungsimpedanzen mit einem Wert R2 gekoppelt, die Abschlussmittelwertbestimmungsimpedanz R2-R1 entspricht, wobei die Verstärkungs- und Impedanzcharakteristiken der genannten Abschlussschaltung und der Abschlussbezugsspannung nicht abweichend sind.

**6.** Analog-Digitalwandler nach Anspruch 1 oder 2, **dadurch gekennzeichnet, dass** in einer Anordnung mit Verstärkerschaltungen mit einer Ausgangsimpedanz von R1 und durch Mittelwertbestimmungsimpedanzen mit einem Wert R2 gekoppelt, wobei R1 > R2 ist, die Abschlussmittelwertbestimmungsimpedanz durch eine aktive Schaltungsanordnung geschaffen wird, wobei die Verstärkungs- und Impedanzcharakteristiken der genannten Abschlussschaltung und der Abschlussbezugsspannung nicht abweichend sind.

**7.** Analog-Digitalwandler nach Anspruch 8, **dadurch gekennzeichnet, dass** das Abschlussnetzwerk eine Anzahl Abschlussschaltungen umfasst, wobei wenigstens zwei Ausgangsspannungsklemmen zweier angrenzender Abschlussschaltungen kurzgeschlossen werden.

**8.** Analog-Digitalwandler nach Anspruch 8, **dadurch gekennzeichnet, dass** das Abschlussnetzwerk zwei Abschlussschaltungen mit kurzgeschlossenen Ausgangsspannungsklemmen umfasst, wobei die Verstärkungsschaltungen weiterhin eine gleichmäßige verteilte Bezugsspannung empfangen und mit der Eingangsspannung verbunden sind, wobei die Ausgangsspannungsklemmen der genannten Verstärkungsschaltungen durch eine Abschlussmittelwertbestimmungsimpedanz mit einer Ausgangsspannungsklemme einer äußeren Verstärkungsschaltung der genannten Anordnung gekoppelt ist, wobei die Abschlussmittelwertbestimmungsimpedanz dem Wert $\dfrac{3}{2}R_2 - \dfrac{1}{2}R_1$ entspricht, wobei die Verstärkungs- und Impedanzcharakteristiken der genannten Abschlussschaltung und der Abschlussbezugsspannungen nicht abweichend sind.

**9.** Verfahren zum Entwerfen eines Analog-Digitalwandlers nach wenigstens einem der Ansprüche 1 bis 8, wobei die Verstärkungs- und Impedanzcharakteristiken der genannten Abschlussschaltung (13) und der Abschlussbezugsspannung im Allgemeinen in der Größe einheitlich sind, in einer Anordnung mit Verstärkerschaltungen mit einer Ausgangsimpedanz von R1 und durch Mittelwertbestimmungsimpedanzen mit einem Wert von R2 gekoppelt, wobei R1 > R2 ist, wobei das Verfahren die nachfolgenden Verfahrensschritte umfasst:

- das Kurzschließen zweier Ausgangsspannungsklemmen zweier benachbarter Abschlussschaltungen in dem Abschlussnetzwerk; und

wobei das Verfahren weiterhin das Wiederholen der nachfolgenden Schritte umfasst:

- das Berechnen einer Größe einer ersten Abschlussimpedanz, die eine Ausgangsspannungsklemme der genannten Abschlussschaltungen mit einer ersten Ausgangsspannungsklemme einer Verstärkungsschaltung, grenzend an die genannte Abschlussschaltung, koppelt, so dass ein Strom durch jede Mittelwertbestimmungsimpedanz zwischen benachbarten Ausgangsspannungsklemmen der genannten Anordnung im Allgemeinen in der Größe im Allgemeinen gleich ist; und
- wenn diese berechnete Größe negativ ist, das Kurzschließen der genannten Ausgangsspannungsklemme der genannten Abschlussschaltung mit der genannten ersten Ausgangsspannungsklemme und das Berechnen einer Größe einer nächsten Abschlussimpedanz, die eine Ausgangsspannungsklemme der genannten Abschlussschaltung mit einer nächsten Ausgangsspannungsklemme einer Verstärkungsschaltung, grenzend an die genannte Abschlussschaltung, koppelt.

**Revendications**

**1.** Convertisseur analogique/numérique, comprenant:

une matrice de circuits d'amplification (2) présentant des caractéristiques d'amplification et d'impédance généralement uniformes, chaque circuit comprenant: une borne de tension d'entrée (6), une borne de tension de référence (7) et une borne de tension de sortie (3);

le convertisseur analogique/numérique comprenant en outre:

un réseau de tension d'entrée (8) fournissant une tension d'entrée analogique à chaque borne de tension d'entrée (6) desdits circuits d'amplification (2);

un réseau de tension de référence (10) fournissant des tensions de référence d'un espacement généralement uniforme à chaque borne de tension de référence (7) desdits circuits d'amplification (2), dans lequel une position fonctionnelle relative de chaque circuit d'amplification (2) est déterminée par la grandeur d'une tension de référence reçue;

un réseau de moyennage (5), comprenant des impédances de moyennage (5) généralement identiques connectant des bornes de tension de sortie (3) de circuits d'amplification (2) adjacents;

un réseau de tension de sortie (12) pour fournir en sortie des différences de tension amplifiée provenant de chacun de ladite pluralité de circuits d'amplification (2), et

**caractérisé par**

un réseau de terminaison (13, 5) comprenant un circuit de terminaison (13) et une impédance de moyennage de terminaison (5), ledit circuit de terminaison (13) recevant la tension d'entrée analogique et une tension de référence de terminaison et ledit circuit de terminaison (13) comprenant une borne de tension de sortie pour produire une tension de sortie en fonction d'une différence entre la tension d'entrée analogique et la tension de référence de terminaison, la borne de tension de sortie étant connectée par l'intermédiaire de ladite impédance de moyennage de terminaison (5) à une borne de tension de sortie (3) d'un circuit d'amplification externe (2) de ladite matrice, les caractéristiques d'amplification et/ou d'impédance dudit circuit de terminaison (13) et/ou la tension de référence de terminaison, et/ou l'impédance de moyennage de terminaison (5) s'écartant, pour générer un courant dans ladite borne de tension de sortie dudit circuit d'amplification externe (2) de ladite matrice, qui est corrigé en fonction de la taille finie de la matrice.

2. Convertisseur analogique/numérique suivant la revendication 1, **caractérisé en ce que** les caractéristiques d'amplification et/ou d'impédance dudit circuit de terminaison (13) et/ou la tension de référence de terminaison, et/ou l'impédance de moyennage de terminaison (5) dudit réseau de terminaison s'écartent de sorte que les courants traversant chaque impédance de moyennage entre des bornes de tension de sortie adjacentes de ladite matrice sont généralement d'égale grandeur.

3. Convertisseur analogique/numérique suivant la revendication 1 ou 2, **caractérisé en ce qu'**une différence de tension entre ladite tension de référence de terminaison et une tension de référence reçue par un circuit d'amplification externe est supérieure par comparaison avec l'espacement généralement uniforme entre chaque tension de référence reçue par lesdits circuits d'amplification, dans lequel les caractéristiques d'amplification et d'impédance dudit circuit de terminaison et l'impédance de moyennage de terminaison ne s'écartent pas.

4. Convertisseur analogique/numérique suivant la revendication 3, **caractérisé en ce que** dans une matrice comprenant des circuits d'amplification comportant une impédance de sortie de R1 et connectés par des impédances de moyennage présentant une valeur de R2, la différence de tension est de préférence supérieure d'un facteur

$$\frac{R1 + R2}{R2}$$ par comparaison avec ledit espacement uniforme.

5. Convertisseur analogique/numérique suivant la revendication 1 ou 2, **caractérisé en ce que** dans une matrice comprenant des circuits d'amplification comportant une impédance de sortie de R1 et connectés par des impédances de moyennage présentant une valeur de R2, l'impédance de moyennage de terminaison est égale à R2-R1, dans lequel les caractéristiques d'amplification et d'impédance dudit circuit de terminaison et la tension de référence de terminaison ne s'écartent pas.

6. Convertisseur analogique/numérique suivant la revendication 1 ou 2, **caractérisé en ce que** dans une matrice comprenant des circuits d'amplification comportant une impédance de sortie de R1 et connectés par des impédances de moyennage présentant une valeur de R2, où R1>R2, l'impédance de moyennage de terminaison est créée par un circuit actif, dans lequel les caractéristiques d'amplification et d'impédance dudit circuit de terminaison et la tension de référence de terminaison ne s'écartent pas.

**7.** Convertisseur analogique/numérique suivant la revendication 6, **caractérisé en ce que** le réseau de terminaison comprend une pluralité de circuits de terminaison, dans lequel deux bornes de tension de sortie au moins de deux circuits de terminaison adjacents sont mises en court-circuit.

**8.** Convertisseur analogique/numérique suivant la revendication 7, **caractérisé en ce que** le réseau de terminaison comprend deux circuits de terminaison comprenant des bornes de tension de sortie qui sont mises en court-circuit, les circuits d'amplification recevant en outre une tension de référence à espacement régulier et étant connectés à la tension d'entrée, dans lequel les bornes de tension de sortie desdits circuits d'amplification sont connectées par une impédance de moyennage de terminaison à une borne de tension de sortie d'un circuit d'amplification externe de ladite matrice, l'impédance de moyennage de terminaison étant égale à $\dfrac{3}{2}R_2 - \dfrac{1}{2}R_1$, dans lequel les caractéristiques d'amplification et d'impédance dudit circuit de terminaison et les tensions de référence de terminaison ne s'écartent pas.

**9.** Procédé de conception d'un convertisseur analogique/numérique suivant une au moins des revendications 1 à 8, dans lequel les caractéristiques d'amplification et d'impédance dudit circuit d'amplification (13) et la tension de référence de terminaison sont généralement de grandeur uniforme, dans une matrice comprenant des circuits d'amplification présentant une impédance de sortie de R1 et connectés par des impédances de moyennage présentant une valeur de R2, dans lequel R1>R2, le procédé comprenant les étapes suivantes:

la mise en court-circuit de deux bornes de tension de sortie de deux circuits de terminaison dans le réseau de terminaison, et
le procédé comprenant en outre la répétition des étapes suivantes:

le calcul d'une grandeur d'une première impédance de terminaison connectant une borne de tension de sortie desdits circuits de terminaison à une première borne de tension de sortie d'un circuit d'amplification adjacent audit circuit d'amplification, de sorte qu'un courant traversant chaque impédance de moyennage entre des bornes de tension de sortie adjacentes de ladite matrice est généralement d'égale grandeur, et si ladite grandeur calculée est négative, la mise en court-circuit de ladite borne de tension de sortie dudit circuit de terminaison à ladite première borne de tension de sortie et le calcul d'une grandeur d'une impédance de terminaison suivante connectant la borne de tension de sortie audit circuit de terminaison à une borne de tension de sortie suivante d'un circuit d'amplification adjacent audit circuit d'amplification.

FIG. 1

**FIG. 2**

FIG. 3

FIG. 4

FIG. 5

FIG. 6